# EUROPÄISCHE PATENTSCHRIFT

(11) **EP 3 603 334 B1**
(45) Veröffentlichungstag und Bekanntmachung des Hinweises auf die Patenterteilung: **11.05.2022**
(21) Anmeldenummer: 18718200.1
(22) Anmeldetag: 12.03.2018
(51) Int. Cl.: H05B 6/06

(54) **HAUSHALTSGERÄTEVORRICHTUNG UND VERFAHREN ZUM BETRIEB EINER HAUSHALTSGERÄTEVORRICHTUNG**
DOMESTIC APPLIANCE DEVICE AND METHOD FOR OPERATING A DOMESTIC APPLIANCE DEVICE
DISPOSITIF POUR APPAREIL MÉNAGER ET PROCÉDÉ POUR FAIRE FONCTIONNER UN DISPOSITIF POUR APPAREIL MÉNAGER

(30) Priorität: 30.03.2017 ES 201730509
(43) Veröffentlichungstag der Anmeldung: 05.02.2020
(73) Patentinhaber: BSH Hausgeräte GmbH, 81739 München (DE)
(72) Erfinder: ACEVEDO SIMON, Arturo, 50009 Zaragoza (ES); CALVO MESTRE, Carlos, 50009 Zaragoza (ES); LAFUENTE URETA, Julio, 50018 Zaragoza (ES); PUYAL PUENTE, Diego, 50014 Zaragoza (ES)
(86) Internationale Anmeldenummer: PCT/IB2018/051621
(87) Internationale Veröffentlichungsnummer: WO 2018/178789

(56) Entgegenhaltungen:
- EP-A1- 3 001 774
- EP-A2- 2 753 147

## Beschreibung

Die Erfindung betrifft eine Haushaltsgerätevorrichtung nach dem Oberbegriff des Anspruchs 1 und ein Verfahren zum Betrieb einer Haushaltsgerätevorrichtung gemäß Anspruch 9.

Aus dem Stand der Technik sind Induktionskochfelder bekannt, die einen Wechselrichter mit zwei Schalteinheiten sowie einen Treiberschaltkreis mit einer Bootstrapeinheit und zumindest zwei Schaltertreibereinheiten umfassen, wobei eine Steuerspannung zumindest einer der Schalteinheiten über die Bootstrapeinheit eingestellt wird. Bei einer unzureichenden und/oder langsamen Ladung der Bootstrapeinheit können dabei störende, akustisch wahrnehmbare Klick-Geräusche auftreten sowie Spannungs- und/oder Stromspitzen entstehen, welche zu Fehlfunktionen und/oder einer Zerstörung der Schalteinheiten führen können.

EP 3 001 774 offenbart eine Haushaltsgerätevorrichtung nach dem Oberbegriff des Anspruchs 1. Die Aufgabe der Erfindung besteht insbesondere darin, eine gattungsgemäße Haushaltsgerätevorrichtung mit verbesserten Eigenschaften hinsichtlich eines Schaltverhaltens bereitzustellen. Die Aufgabe wird durch die kennzeichnenden Merkmale des Anspruchs 1 und die Merkmale des Anspruchs 10 gelöst, während vorteilhafte Ausgestaltungen und Weiterbildungen der Erfindung den Unteransprüchen entnommen werden können.

Die Erfindung geht aus von einer Haushaltsgerätevorrichtung, insbesondere einer Gargerätevorrichtung, mit zumindest einer Schaltertreibereinheit, welche dazu vorgesehen ist, zumindest eine Schalteinheit zu versorgen, und mit einer Bootstrapeinheit, welche zur Bereitstellung zumindest einer Versorgungsspannung für die Schaltertreibereinheit vorgesehen ist.

Es wird vorgeschlagen, dass die Haushaltsgerätevorrichtung zumindest eine Anpassungseinheit aufweist, welche in zumindest einem Betriebszustand zur Anpassung der Versorgungsspannung in Abhängigkeit von zumindest einer elektrischen Schaltertreiberkenngröße der Schaltertreibereinheit vorgesehen ist, und welche eine Erfassungseinheit aufweist, welche zu einer Erfassung der Schaltertreiberkenngröße vorgesehen ist. Durch diese Ausgestaltung kann eine Haushaltsgerätevorrichtung mit verbesserten Eigenschaften hinsichtlich eines Schaltverhaltens bereitgestellt werden. Insbesondere kann vorteilhaft bei einem Startvorgang eine schnellere Ladung der Bootstrapeinheit erreicht werden, wodurch vorteilhaft eine Geräuscherzeugung während des Startvorgangs reduziert werden kann. Zudem kann insbesondere in zumindest einem Betriebszustand eine Versorgungsspannung zu einem Betrieb des Wechselrichters, insbesondere einer Schalteinheit, konstant gehalten werden, womit Strom- und/oder Spannungsspitzen vorteilhaft verhindert werden können. Ferner kann insbesondere eine Funktionsstabilität erhöht und/oder eine Materialbeanspruchung, insbesondere der Schalteinheit und/oder der Schaltertreibereinheit, reduziert werden, wodurch eine Lebenszeit der Haushaltsgerätevorrichtung vorteilhaft erhöht werden kann. Ferner können insbesondere Reparatur- und Materialkosten gering gehalten werden.

Unter einer "Haushaltsgerätevorrichtung" soll in diesem Zusammenhang insbesondere zumindest ein Teil, insbesondere eine Unterbaugruppe, eines Haushaltsgeräts, insbesondere eines Gargeräts, vorzugsweise eines Kochfelds und besonders bevorzugt eines Induktionskochfelds, verstanden werden. Insbesondere kann die Haushaltsgerätevorrichtung auch die zumindest eine Schalteinheit umfassen. Darüber hinaus kann die Haushaltsgerätevorrichtung insbesondere eine Steuereinheit, wenigstens einen Wechselrichter, eine Heizeinheit mit wenigstens einem Heizelement, welches vorzugsweise als Induktionsheizelement ausgebildet ist, und/oder eine Spannungsversorgungseinheit, beispielsweise in Form eines Spannungsnetzteils, zur Bereitstellung einer vorteilhaft positiven Hauptversorgungsspannung umfassen. Vorteilhaft umfasst der Wechselrichter die Schalteinheit. Unter einer "Schalteinheit" soll insbesondere eine Einheit mit zumindest einem Schaltelement verstanden werden, welche dazu vorgesehen ist, einen elektrischen Strom, insbesondere periodisch, zu schalten. Unter einem "Schaltelement" soll insbesondere ein Element verstanden werden, welches insbesondere wenigstens zwei Schaltzustände aufweist und insbesondere dazu vorgesehen ist, in zumindest einem der Schaltzustände zumindest eine elektrisch leitfähige Verbindung zwischen zumindest zwei Leitungskontakten herzustellen und/oder zu trennen. Vorzugsweise umfasst das Schaltelement dabei wenigstens einen Steueranschluss und ist insbesondere dazu vorgesehen, einen Schaltzustand in Abhängigkeit von zumindest einem Steuersignal, insbesondere einer an dem Steueranschluss des Schaltelements anliegenden elektrischen Spannung und/oder einem an dem Steueranschluss des Schaltelements anliegenden elektrischem Steuerpotential, zu ändern und/oder zu wechseln. Bevorzugt ist das Schaltelement als ein Leistungsschaltelement ausgebildet. Unter einem "Leistungsschaltelement" soll insbesondere ein Schaltelement verstanden werden, welches dazu vorgesehen ist, in zumindest einem Schaltzustand einen mittleren Strom von zumindest 0,5 A, insbesondere zumindest 1 A, vorteilhaft zumindest 4 A, vorzugsweise zumindest 10 A, zu schalten. Vorteilhaft ist das Leistungsschaltelement als Halbleiterschaltelement, insbesondere als Transistor, insbesondere als MOSFET und/oder vorteilhaft als IGBT ausgebildet. Vorzugsweise weist die Haushaltsgerätevorrichtung und insbesondere der Wechselrichter zumindest eine weitere Schalteinheit auf, welche vorteilhaft ein als Leistungsschaltelement ausgebildetes weiteres Schaltelement aufweist.

Ferner soll unter einer "Schaltertreibereinheit" insbesondere eine elektronische Einheit verstanden werden, welche insbesondere einen Schaltertreibereingang, einen Schaltertreiberausgang und/oder vorzugsweise zwei Versorgungsspannungsanschlüsse umfasst und insbesondere dazu vorgesehen ist, in zumindest einem Betriebszustand, insbesondere in einem Betriebszustand, in welchem eine an den zwei Versorgungsspannungsanschlüssen anliegende Versorgungsspannung einen Grenzwert überschreitet, ein, insbesondere an dem Schaltertreibereingang anliegendes, Spannungssignal, insbesondere der Anpassungseinheit und/oder der Bootstrapeinheit, der Steuereinheit, insbesondere dem Steueranschluss des Schaltelements, zuzuführen. Bevorzugt ist die Schaltertreibereinheit elektrisch parallel zu der Bootstrapeinheit geschalten. Unter einer "Schaltertreiberkenngröße" soll insbesondere eine Kenngröße der Schaltertreibereinheit verstanden werden, welche mit der Versorgungsspannung und/oder bevorzugt mit einem Verbrauchsstrom, vorteilhaft mit einem Eingangsstrom, der Schaltertreibereinheit korreliert ist. Insbesondere kann die Schalttreiberkenngröße auch einen Wert aufweisen, welcher vorteilhaft proportional zu einem Wert des Entladestroms, der Entladespannung und/oder des Ladepotentials ausgebildet ist. Vorteilhaft ist die Schaltertreiberkenngröße, insbesondere der Eingangsstrom, der Schaltertreibereinheit mit der Schaltfrequenz der Heizeinheit, vorteilhaft des zumindest einen Heizelements der Heizeinheit, korreliert. Unter einer "Bootstrapeinheit" soll insbesondere eine Einheit verstanden werden, welche dazu vorgesehen ist, eine Bootstrapspannung zu erzeugen und/oder bereitzustellen und insbesondere den zwei Versorgungsspannungsanschlüssen der Schaltertreibereinheit zuzuführen, wodurch vorzugsweise ein Schaltzustand der Schalteinheit gesteuert werden kann. Vorteilhaft entspricht die Bootstrapspannung dabei der, insbesondere an den zwei Versorgungsspannungsanschlüssen anliegenden, Versorgungsspannung der Schaltertreibereinheit. Dazu umfasst die Bootstrapeinheit vorteilhaft zumindest eine Bootstrapkapazität und/oder zumindest eine Bootstrapdiode. In diesem Zusammenhang soll unter einer "Bootstrapkapazität" insbesondere eine Einheit verstanden werden, welche zumindest eine Kapazität, umfasst und insbesondere dazu vorgesehen ist, Energie, insbesondere die Bootstrapspannung, insbesondere zu einer Versorgung der Schaltertreibereinheit, zumindest temporär zu speichern. Vorteilhaft ist die Bootstrapkapazität dabei als Kondensator ausgebildet.

Unter einer "Anpassungseinheit" soll insbesondere eine, vorteilhaft mit der Schaltertreibereinheit elektrisch verbundene, Einheit verstanden werden, welche zur Anpassung der Versorgungsspannung vorgesehen ist. Vorzugsweise ist die Anpassungseinheit dazu vorgesehen, die Versorgungsspannung der Bootstrapeinheit für die Schaltertreibereinheit derart anzupassen, dass die Schaltertreiberkenngröße optimiert wird. Bevorzugt ist die Anpassungseinheit elektrisch in Reihe mit der Schaltertreibereinheit und/oder der Bootstrapeinheit geschaltet. Unter dem Ausdruck "Anpassung" soll insbesondere eine Optimierung und/oder eine Angleichung, insbesondere der Versorgungsspannung, an einen vorteilhaften Betrieb verstanden werden. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Ferner wird vorgeschlagen, dass die Schalteinheit als eine High-Side Leistungsschalteinheit ausgebildet ist. Unter einer "High-Side-Leistungsschalteinheit" soll insbesondere eine Schalteinheit mit zumindest einem als Leistungsschaltelement ausgebildeten Schaltelement verstanden werden, welches insbesondere Teil eines Wechselrichters ist und insbesondere von einer von der Hauptversorgungsspannung verschiedenen Spannung, insbesondere der Bootstrapeinheit, versorgt wird. Dadurch kann vorteilhaft ein verbessertes Schaltverhalten erreicht werden.

In einer Ausgestaltung der Erfindung wird vorgeschlagen, dass die Anpassungseinheit eine Spannungseinstelleinheit umfasst, welche elektrisch zwischen einer Spannungsversorgungseinheit und der Bootstrapeinheit geschalten und dazu vorgesehen ist, die Versorgungsspannung anzupassen. Unter einer "Spannungseinstelleinheit" soll eine Einheit verstanden werden, welche dazu vorgesehen ist, die Versorgungsspannung in Abhängigkeit von der Schaltertreiberkenngröße einzustellen, insbesondere zu erhöhen oder zu reduzieren. Vorzugsweise umfasst die Spannungseinstelleinheit zumindest ein Spannungseinstellelement, welches als ein elektrischer Spannungsregler, als ein Schaltregler, als ein, vorteilhaft einstellbarer, elektrischer Widerstand und/oder als elektrischer Spannungsteiler ausgebildet ist und insbesondere dazu vorgesehen ist, die Versorgungsspannung einzustellen. Vorteilhaft ist die Schaltertreiberkenngröße proportional zu der Versorgungsspannung, sodass eine Einstellung der Versorgungsspannung insbesondere eine Veränderung der Schaltertreiberkenngröße bewirkt. Besonders vorteilhaft ist die Spannungseinstelleinheit elektrisch mit der Spannungsversorgungseinheit, der Bootstrapeinheit und/oder der Schaltertreibereinheit verbunden. Dadurch kann vorteilhaft eine verbesserte Anpassung einer Versorgungsspannung erreicht werden und insbesondere ein Schaltverhalten verbessert und eine Geräuscherzeugung verhindert werden.

Um insbesondere eine schnellere Ladung der Bootstrapeinheit zu erreichen und dadurch vorteilhaft eine Geräuscherzeugung zu reduzieren wird vorgeschlagen, dass die Spannungseinstelleinheit dazu vorgesehen ist, in zumindest einem Startbetriebszustand die Versorgungsspannung zu erhöhen. Unter einem "Startbetriebszustand" soll in diesem Zusammenhang insbesondere ein Betriebszustand verstanden werden, welcher, insbesondere unmittelbar, nach einem Starten der Haushaltsgerätevorrichtung und/oder einer Auswahl eines Betriebsprogramms und/oder einem Wechsel eines Betriebsprogramms startet. Die Bootstrapeinheit, insbesondere die Bootstrapkapazität, ist dabei vorteilhaft zu Beginn des Startbetriebszustands vollständig entladen, insbesondere über einen längeren Zeitraum von insbesondere zumindest 1 ms, vorteilhaft zumindest 0,5 s, vorzugsweise zumindest 1 s und besonders bevorzugt zumindest 5 s. Insbesondere ändert sich und/oder steigt ein in der Bootstrapkapazität gespeicherter Spannungswert und/oder effektiver Spannungswert und/oder eine Bootstrapspannung während des Startbetriebszustands. Vorteilhaft ist ein Startvorgang der Haushaltsgerätevorrichtung in dem Startbetriebszustand als ein Soft-Start ausgebildet.

Weiterhin wird vorgeschlagen, dass die Spannungseinstelleinheit dazu vorgesehen ist, in zumindest einem Dauerbetriebszustand einen Wert der Versorgungsspannung unterhalb einem Schwellenwert zu halten. Vorzugsweise steuert die Spannungseinstelleinheit die Versorgungsspannung derart, dass die Versorgungsspannung den Schwellenwert, insbesondere einen Wert, unterhalb welchem eine Erzeugung von Stromspitzen verhindert ist, nicht überschreitet. Dadurch kann insbesondere eine Erzeugung von Stromspitzen verhindert und eine Materialbeanspruchung, insbesondere der Schalteinheit, reduziert werden. Zudem können insbesondere eine Lebensdauer erhöht und ein Reparaturaufwand verringert werden. Unter einem "Dauerbetriebszustand" soll in diesem Zusammenhang insbesondere ein Betriebszustand verstanden werden, welcher, vorzugsweise unmittelbar, an den Startbetriebszustand anschließt. Insbesondere ist ein maximaler in der Bootstrapkapazität gespeicherter Spannungswert und/oder effektiver Spannungswert und/oder eine maximale Bootstrapspannung in dem Dauerbetriebszustand zumindest zwischen zwei Schaltvorgängen der Schalteinheit und vorzugsweise zwischen allen Schaltvorgängen der Schalteinheit zumindest im Wesentlichen konstant. In diesem Zusammenhang soll unter "zumindest im Wesentlichen konstant" insbesondere eine Änderung um maximal 5 %, vorzugsweise um maximal 2 % und besonders bevorzugt um maximal 1 % verstanden werden.

Erfindungsgemäß weist die Anpassungseinheit eine Erfassungseinheit auf, welche zu einer Erfassung der Schaltertreiberkenngröße vorgesehen ist. Die Erfassungseinheit ist vorteilhaft elektrisch mit der Spannungseinstelleinheit verbunden und insbesondere dazu vorgesehen, die Schaltertreiberkenngröße zu erfassen und ein zu einem erfassten Wert der Schaltertreiberkenngröße korrespondierendes, bevorzugt ein zu dem erfassten Wert der Schaltertreiberkenngröße proportionales, Signal bereitzustellen. Vorzugsweise ist die Anpassungseinheit selbststeuernd ausgebildet. Unter "selbststeuernd" soll in diesem Zusammenhang insbesondere selbstregulierend, selbstanpassend und/oder automatisch verstanden werden. Darunter, dass die "Anpassungseinheit selbststeuernd ausgebildet ist", soll insbesondere verstanden werden, dass die Anpassungseinheit die Versorgungsspannung in Abhängigkeit von der elektrischen Schaltertreiberkenngröße der Schaltertreibereinheit automatisch und/oder selbsttätig, vorteilhaft in Abhängigkeit eines Feedbacksignals der Schalteinheit, der Schaltertreibereinheit, der Bootstrapeinheit und/oder vorteilhaft der Erfassungseinheit, anpasst. Vorteilhaft ist die Anpassungseinheit dabei dazu vorgesehen, die Versorgungsspannung in Abhängigkeit von der elektrischen Schaltertreiberkenngröße der Schaltertreibereinheit zu regeln. Insbesondere kann die Anpassungseinheit dabei frei von einer, insbesondere direkten, Verbindung zu der Steuereinheit und/oder einer Ansteuerung durch die Steuereinheit sein. Durch diese Ausgestaltung kann eine besonders einfache Anpassungseinheit erreicht und vorteilhaft eine Anpassung durch die Anpassungseinheit weiter verbessert werden.

Insbesondere könnte die Schaltertreiberkenngröße ein Steuerpotential an einem Leitungsanschluss der Schalteinheit und/oder ein Ladepotential der Bootstrapeinheit sein. Bevorzugt wird jedoch vorgeschlagen, dass die Schaltertreiberkenngröße ein elektrischer Eingangsstrom der Schaltertreibereinheit ist und die Erfassungseinheit dazu vorgesehen ist, den elektrischen Eingangsstrom zu erfassen, insbesondere zu detektieren und/oder zu messen, und vorteilhaft als Feedbacksignal bereitzustellen. Dadurch kann vorteilhaft eine einfache Erfassung der Schaltertreiberkenngröße erreicht werden.

In einer bevorzugten Ausgestaltung der Erfindung wird vorgeschlagen, dass die Erfassungseinheit zumindest ein als Stromsensor ausgebildetes Erfassungselement aufweist. Bevorzugt ist das Erfassungselement als ein Stromtransformator, ein elektrischer Messwiderstand und/oder als eine Messdiode ausgebildet. Besonders bevorzugt ist das Erfassungselement dazu vorgesehen, den Eingangsstrom der Schaltertreibereinheit in ein zu dem Eingangsstrom proportionales elektromagnetisches Signal umzuwandeln und vorteilhaft als Feedbacksignal bereitzustellen. Dadurch kann insbesondere eine Anpassungseinheit ausgebildet werden, welche den Eingangsstrom minimal abschwächt, wodurch vorteilhaft eine besonders verbesserte Erfassung des Eingangsstroms und dadurch eine Anpassungseinheit verbessert werden kann.

Erfindungsgemäß wird ein Verfahren zum Betrieb einer Haushaltsgerätevorrichtung vorgeschlagen, welche zumindest eine Schaltertreibereinheit, welche dazu vorgesehen ist, zumindest eine Schalteinheit zu versorgen, und eine Bootstrapeinheit umfasst, welche zur Bereitstellung zumindest einer Versorgungsspannung für die Schaltertreibereinheit vorgesehen ist, wobei in zumindest einem Betriebszustand die Versorgungsspannung in Abhängigkeit von zumindest einer elektrischen Schaltertreiberkenngröße der Schaltertreibereinheit erfasst und angepasst wird. Durch diese Ausgestaltung kann eine Haushaltsgerätevorrichtung mit verbesserten Eigenschaften hinsichtlich eines Schaltverhaltens bereitgestellt werden. Insbesondere kann vorteilhaft bei einem Startvorgang eine schnellere Ladung der Bootstrapeinheit erreicht werden, wodurch vorteilhaft eine Geräuscherzeugung während des Startvorgangs reduziert werden kann. Zudem kann insbesondere in zumindest einem Betriebszustand eine Versorgungsspannung zu einem Betrieb des Wechselrichters, insbesondere einer Schalteinheit, konstant gehalten werden, womit Strom- und/oder Spannungsspitzen vorteilhaft verhindert werden können. Ferner kann insbesondere eine Funktionsstabilität erhöht und/oder eine Materialbeanspruchung, insbesondere der Schalteinheit und/oder der Schaltertreibereinheit, reduziert werden, wodurch eine Lebenszeit der Haushaltsgerätevorrichtung vorteilhaft erhöht werden kann. Ferner können insbesondere Reparatur- und Materialkosten gering gehalten werden.

Die Haushaltsgerätevorrichtung und das Verfahren zum Betrieb der Haushaltsgerätevorrichtung sollen hierbei nicht auf die oben beschriebene Anwendung und Ausführungsform beschränkt sein. Insbesondere können die Haushaltsgerätevorrichtung und das Verfahren zum Betrieb der Haushaltsgerätevorrichtung zu einer Erfüllung einer hierin beschriebenen Funktionsweise eine von einer hierin genannten Anzahl von einzelnen Elementen, Bauteilen und Einheiten abweichende Anzahl aufweisen.

Weitere Vorteile ergeben sich aus der folgenden Zeichnungsbeschreibung. In den Zeichnungen ist ein Ausführungsbeispiel der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein als Kochfeld ausgebildetes Haushaltsgerät mit einer Haushaltsgerätevorrichtung in einer Draufsicht,
- Fig. 2: ein Schaltdiagramm der Haushaltsgerätevorrichtung,
- Fig. 3: ein Schaubild einer Anpassung in einem Startbetriebszustand und
- Fig. 4: ein Schaubild einer weiteren Anpassung in einem Dauerbetriebszustand.

### Beschreibung des Ausführungsbeispiels

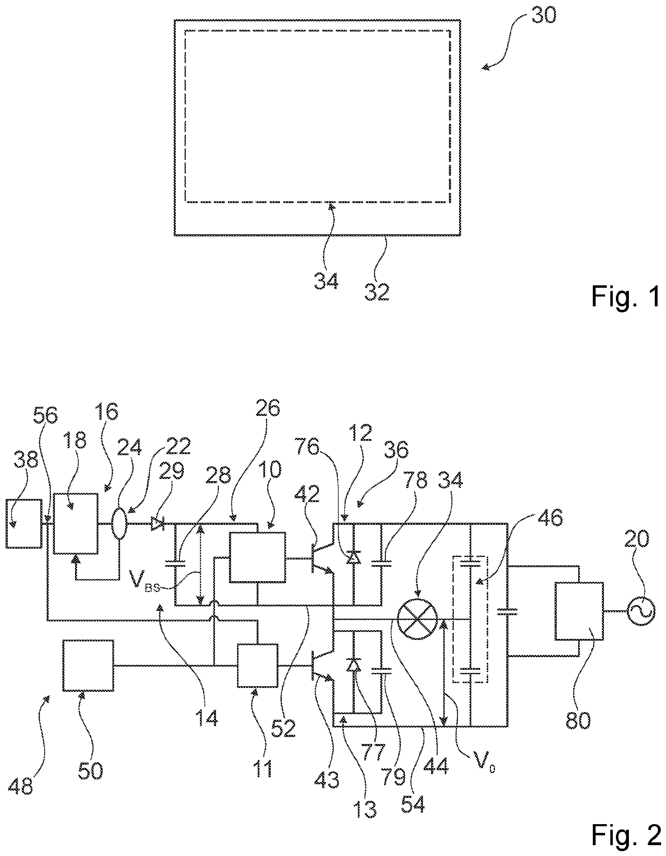

Figur 1 zeigt ein als Induktionskochfeld ausgebildetes Haushaltsgerät 30. Das Haushaltsgerät 30 weist eine Kochfeldplatte 32 auf. Das Haushaltsgerät 30 weist eine Haushaltsgerätevorrichtung auf. Alternativ könnte ein Haushaltsgerät auch als Backofen, wie beispielsweise Induktionsbackofen, und/oder als ein Kühlschrank und/oder als ein Geschirrspüler ausgebildet sein.
Figur 2 zeigt ein Schaltdiagramm der Haushaltsgerätevorrichtung. Die Haushaltsgerätevorrichtung weist eine Heizeinheit 34 auf. Die Heizeinheit 34 kann mehrere Induktoren (nicht dargestellt) umfassen. Zudem kann die Heizeinheit 34 eine Schaltanordnung (nicht dargestellt) umfassen, um die Induktoren abwechselnd und/oder gemeinsam, beispielsweise in einem Zeit-Multiplex-Verfahren, zu betreiben. Die Haushaltsgerätevorrichtung weist eine Hauptenergieversorgung 20 und einen Gleichrichter 80 zur Versorgung der Heizeinheit 34 auf.

Ferner umfasst die Haushaltsgerätevorrichtung einen Wechselrichter 36. Der Wechselrichter 36 umfasst zwei Schalteinheiten 12, 13. Die Schalteinheiten 12, 13 sind identisch zueinander ausgebildet. Die Schalteinheiten 12, 13 umfassen jeweils einen Steuereingang. Zudem umfassen die Schalteinheiten 12, 13 jeweils ein Schaltelement 42, 43. Die Schaltelemente 42, 43 sind als Leistungsschaltelemente ausgebildet. Die Schaltelemente 42, 43 sind als IGBTs ausgebildet. Die erste Schalteinheit 12 ist als High-Side Leistungsschalteinheit ausgebildet. Die zweite Schalteinheit 13 ist als Low-Side Leistungsschalteinheit ausgebildet. Ferner umfassen die Schalteinheiten 12, 13 jeweils eine Freilaufdiode 76, 77 und eine Snubberkapazität 78, 79, welche insbesondere parallel zu den Schaltelementen 42, 43 geschaltet sind. Alternativ ist auch denkbar, dass eine Haushaltsgerätevorrichtung mehrere Wechselrichter aufweist. Zudem ist denkbar, dass zumindest ein Wechselrichter unterschiedliche Schalteinheiten aufweist.

Ein erster Anschluss der Hauptenergieversorgung 20 ist dabei mit einem ersten Anschluss der ersten Schalteinheit 12 der Schalteinheiten 12, 13 verbunden. Unter "verbunden" soll hier und im Folgenden elektrisch leitend verbunden verstanden werden. Der erste Anschluss der Hauptenergieversorgung 20 ist mit einem Kollektoranschluss des Schaltelements 42 der ersten Schalteinheit 12 verbunden. Ein zweiter Anschluss der Hauptenergieversorgung 20 ist mit einem zweiten Anschluss der zweiten Schalteinheit 13 der Schalteinheiten 12, 13 verbunden. Der zweite Anschluss der Hauptenergieversorgung 20 ist mit einem Emitteranschluss des Schaltelements 43 der zweiten Schalteinheit 13 verbunden. Der Wechselrichter 36 ist dazu vorgesehen, eine pulsierende gleichgerichtete Netzspannung der Hauptenergieversorgung 20 in einen hochfrequenten Heizstrom umzuwandeln und insbesondere der Heizeinheit 34 zuzuführen. Die Heizeinheit 34 ist dabei in einem Brückenzweig zwischen einem Mittelabgriff 44 des Wechselrichters 36 und einer Resonanzeinheit 46 angeordnet.

Zudem umfasst die Haushaltsgerätevorrichtung einen Treiberschaltkreis 48. Der Treiberschaltkreis 48 ist dazu vorgesehen, eine Steuerspannung für die Schalteinheiten 12, 13 einzustellen. Dazu weist der Treiberschaltkreis 48 eine Spannungsversorgungseinheit 38 auf.

Der Treiberschaltkreis 48 weist zwei Schaltertreibereinheiten 10, 11 auf. Die Schaltertreibereinheiten 10, 11 sind identisch zueinander ausgebildet. Alternativ ist auch denkbar, unterschiedliche Schaltertreibereinheiten zu verwenden. Die Schaltertreibereinheiten 10, 11 sind als Hochspannungs-IC (High-Voltage Integrated Circuit) ausgebildet. Jede der Schaltertreibereinheiten 10, 11 weist einen Schaltertreibereingang und einen Schaltertreiberausgang auf. Zudem weist jede der Schaltertreibereinheiten 10, 11 zwei Versorgungsspannungsanschlüsse auf. Eine erste Schaltertreibereinheit 10 der Schaltertreibereinheiten 10, 11 ist dazu vorgesehen, die erste Schalteinheit 12 zu betreiben. Die erste Schaltertreibereinheit 10 ist mit einem Steueranschluss der ersten Schalteinheit 12 verbunden. Die erste Schaltertreibereinheit 10 ist dazu vorgesehen, mittels eines Schaltpotentials an dem Steueranschluss der ersten Schalteinheit 12 die erste Schalteinheit 12 zu schalten. Eine zweite Schaltertreibereinheit 11 der Schaltertreibereinheiten 10, 11 ist dazu vorgesehen, die zweite Schalteinheit 13 zu betreiben. Die zweite Schaltertreibereinheit 11 ist mit einem Steueranschluss der zweiten Schalteinheit 13 verbunden. Die zweite Schaltertreibereinheit 11 ist dazu vorgesehen, mittels eines Schaltpotentials an dem Steueranschluss der zweiten Schalteinheit 13 die zweite Schalteinheit 13 zu schalten.

Der Treiberschaltkreis 48 weist eine Steuereinheit 50 auf. Die Steuereinheit 50 ist mit einem Schaltertreibereingang der ersten Schaltertreibereinheit 10 verbunden. Die Steuereinheit 50 ist mit einem Schaltertreibereingang der zweiten Schaltertreibereinheit 11 verbunden. Die Steuereinheit 50 ist dazu vorgesehen, der ersten Schaltertreibereinheit 10 und der zweiten Schaltertreibereinheit 11 eine Frequenz zum Schalten der Schalteinheiten 12, 13 vorzugeben. Die Steuereinheit 50 ist dazu vorgesehen, die Frequenz zum Schalten der Schalteinheiten 12, 13 der Haushaltsgerätevorrichtung zu verändern.

Der Treiberschaltkreis 48 weist eine Bootstrapeinheit 14 auf. Die Bootstrapeinheit 14 umfasst eine Bootstrapdiode 29. Die Bootstrapeinheit 14 umfasst einen Bootstrapkondensator 28. Der Bootstrapkondensator 28 ist als Energiepuffer ausgebildet. Der Bootstrapkondensator 28 weist einen spannungsabhängigen Kapazitätswert auf. Alternativ ist auch denkbar, dass ein Bootstrapkondensator spannungsunabhängig ausgebildet ist.

Die Bootstrapdiode 29 ist mit einem Anodenanschluss mit dem zweiten Anschluss der Spannungsversorgungseinheit 38 verbunden. Ein erster Anschluss des Bootstrapkondensators 28 ist mit einem Kathodenanschluss der Bootstrapdiode 29 verbunden. Ein erster Anschluss des Bootstrapkondensators 28 ist zudem mit einem ersten Versorgungsspannungsanschluss der zweiten Schaltertreibereinheit 11 verbunden. Ein zweiter Anschluss des Bootstrapkondensators 28 ist über einen Leitungspfad 52 mit dem Mittelabgriff 44 verbunden. Demnach ist der Bootstrapkondensators 28 mit einem Kollektoranschluss der zweiten Schalteinheit 13 und/oder des Schaltelements 43 der zweiten Schalteinheit 13 und einem Emitteranschluss der ersten Schalteinheit 12 und/oder des Schaltelements 42 der ersten Schalteinheit 12 verbunden. Ferner ist der Bootstrapkondensator 28 über den Leitungspfad 52 mit einem zweiten Versorgungsspannungsanschluss der ersten Schaltertreibereinheit 10 verbunden. Der Leitungspfad 52 dient als Referenzspannungsanschluss für die erste Schalteinheit 12. Der Leitungspfad 52 liegt auf einem Potential zwischen der Versorgungsspannung 56 und einem Referenzpotential 54. Der Leitungspfad 52 liegt in einem Betriebszustand, in welchem die Schalteinheiten 12, 13 abwechselnd auf einem Referenzpotential 54 oder einem Netzspannungspotential V₀ geschalten sind. Der Bootstrapkondensator 28 ist dazu vorgesehen, eine Bootstrapspannung V_{BS} bereitzustellen. Die Bootstrapspannung V_{BS} entspricht dabei einer Versorgungsspannung 56 der ersten Schaltertreibereinheit 10 aus der Spannungsversorgungseinheit 38 und liegt insbesondere in zumindest einem Betriebszustand an den Versorgungsspannungsanschlüssen der ersten Schaltertreibereinheit 10 an.

Die Eingangsspannung der Bootstrapeinheit 14 entspricht dabei einer Überlagerung des Netzspannungspotentials V₀ und des Spannungspotentials der Spannungsversorgungseinheit 38. Die Bootstrapspannung V_{BS} entspricht zumindest im Wesentlichen einer Einhüllenden der Eingangsspannung und insbesondere der Versorgungsspannung 56 der ersten Schaltertreibereinheit 10. Die Bootstrapspannung V_{BS} ist in einem Vergleich zu der optimalen Versorgungsspannung 56 der ersten Schaltertreibereinheit 10 zumindest in dem Startbetriebszustand erhöht, was insbesondere zu einer Zerstörung und/oder zu einer Fehlfunktion der ersten Schaltertreibereinheit 10 führen kann. Insbesondere entspricht die Bootstrapspannung V_{BS} in dem Dauerbetriebszustand zumindest im Wesentlichen der optimalen Versorgungsspannung 56 der ersten Schaltertreibereinheit 10, wodurch einer Zerstörung und/oder einer Fehlfunktion der ersten Schaltertreibereinheit 10 vorteilhaft entgegengewirkt werden kann.

In einem Betriebszustand werden die Schalteinheiten 12, 13 abwechselnd geschaltet. Somit ist wenigstens zu einem ersten Schaltzeitpunkt die zweite Schalteinheit 13 offen und die erste Schalteinheit 12 geschlossen und wenigstens zu einem insbesondere von dem ersten Schaltzeitpunkt verschiedenen, zweiten Schaltzeitpunkt die zweite Schalteinheit 13 geschlossen und die erste Schalteinheit 12 offen. Dabei wird der Bootstrapkondensator 28 abwechselnd aufgeladen und entladen. Der Bootstrapkondensator 28 wird während einer Aktivierung der ersten Schalteinheit 12 entladen. Der Bootstrapkondensator 28 wird während einer Aktivierung der zweiten Schalteinheit 13 mittels der Spannungsversorgungseinheit 38 über die Bootstrapdiode 29 aufgeladen.

Der Treiberschaltkreis 48 weist eine Anpassungseinheit 16 auf. Ein erster Anschluss der Anpassungseinheit 16 ist mit der Spannungsversorgungseinheit 38 elektrisch leitend verbunden. Zudem ist der erste Anschluss der Anpassungseinheit 16 mit einem Versorgungsspannungsanschluss der ersten Schaltertreibereinheit 10 verbunden. Ein zweiter Anschluss der Anpassungseinheit 16 ist mit dem Anodenanschluss der Bootstrapdiode 29 elektrisch leitend verbunden. Die Anpassungseinheit 16 ist dazu vorgesehen, in zumindest einem Betriebszustand die Versorgungsspannung 56 in Abhängigkeit von einer elektrischen Schaltertreiberkenngröße der ersten Schaltertreibereinheit 10 anzupassen.

Die Anpassungseinheit 16 weist eine Spannungseinstelleinheit 18 auf. Die Spannungseinstelleinheit 18 ist elektrisch zwischen der Spannungsversorgungseinheit 38 und der Bootstrapeinheit 14 geschaltet. Ein erster Anschluss der Spannungseinstelleinheit 18 ist verbunden mit der Spannungsversorgungseinheit 38. Ein zweiter Anschluss der Spannungseinstelleinheit 18 ist verbunden mit dem Anodeneingang der Bootstrapdiode 29. Die Spannungseinstelleinheit 18 ist dazu vorgesehen, die Versorgungsspannung 56 anzupassen. Die Spannungseinstelleinheit 18 ist dazu vorgesehen, in einem Startbetriebszustand die Versorgungsspannung 56 zu erhöhen. Die Spannungseinstelleinheit 18 ist dazu vorgesehen, in zumindest einem Dauerbetriebszustand einen Wert der Versorgungsspannung 56 unterhalb einem Schwellenwert zu halten. Die Spannungseinstelleinheit 18 weist dazu zumindest ein (hier nicht gezeigtes) Spannungseinstellelement zu einer Einstellung eines Spannungswerts auf. Das Spannungseinstellelement ist im vorliegenden Fall als ein Schaltregler ausgebildet. Alternativ kann ein Spannungseinstellelement als ein elektrischer Spannungsregler, als Potentiometer und/oder als elektrischer Widerstand ausgebildet sein.

Die Anpassungseinheit 16 weist eine Erfassungseinheit 22 auf. Die Erfassungseinheit 22 ist zwischen der Spannungseinstelleinheit 18 und der Bootstrapeinheit 14 angeordnet. Die Erfassungseinheit 22 ist zwischen der Spannungseinstelleinheit 18 und der ersten Schaltertreibereinheit 10 angeordnet. Die Erfassungseinheit 22 ist elektrisch zwischen der Spannungseinstelleinheit 18 und der Bootstrapdiode 29 angeordnet. Die Erfassungseinheit 22 ist zu einer Erfassung der Schaltertreiberkenngröße vorgesehen. Die Erfassungseinheit 22 ist dazu vorgesehen, den elektrischen Eingangsstrom 26 der ersten Schaltertreibereinheit 10 zu erfassen. Die Erfassungseinheit 22 weist zumindest ein Erfassungselement 24 auf. Das Erfassungselement 24 ist zwischen der Spannungseinstelleinheit 18 und der ersten Schaltertreibereinheit 10 angeordnet. Die Erfassungseinheit 22 ist elektrisch leitend mit der Spannungseinstelleinheit 18 verbunden. Das Erfassungselement 24 ist zu einer Erfassung der Schaltertreiberkenngröße vorgesehen. Das Erfassungselement 24 ist dazu vorgesehen, den elektrischen Eingangsstrom 26 der ersten Schaltertreibereinheit 10 zu erfassen. Das Erfassungselement 24 ist als Stromsensor ausgebildet. Das Erfassungselement 24 ist als induktives Bauteil ausgebildet. Das Erfassungselement 24 ist als ein Stromtransformator ausgebildet. Das Erfassungselement 24 erfasst einen durch einen Strom erzeugten magnetischen Fluss in dem Stromtransformator. Das Erfassungselement 24 erfasst einen durch den Eingangsstrom 26 erzeugten magnetischen Fluss. Alternativ kann ein Erfassungselement auch als eine Messdiode, Messspule und/oder als ein elektrischer Messwiderstand ausgebildet sein.

In einem Startbetriebszustand erfolgt ein Starten der Haushaltsgerätevorrichtung mittels eines Soft-Start. Während des Soft-Start schalten die Schalteinheiten 12, 13 bei einem Startvorgang direkt nach einem Einschalten der Haushaltsgerätevorrichtung mit einer hohen Schaltfrequenz, wobei die Steuereinheit 50 die Schaltfrequenz schrittweise verringert. Die hohe Schaltfrequenz erfordert eine besonders schnelle Ladung des Bootstrapkondensators 28. Die Anpassungseinheit 16 ist dazu vorgesehen, die Versorgungsspannung 56 zu erhöhen. Die Spannungseinstelleinheit 18 ist dazu vorgesehen, die Versorgungsspannung 56 zu erhöhen. Die Versorgungsspannung 56 bewirkt einen Eingangsstrom 26 der ersten Schaltertreibereinheit 10. Der Eingangsstrom 26 wird von der Erfassungseinheit 22 erfasst. Ein zu dem erfassten Eingangsstrom 26 korreliertes Signal stellt die Erfassungseinheit 22 für die Spannungseinstelleinheit 18 bereit. Die Spannungseinstelleinheit 18 stellt einen höheren Wert der Versorgungsspannung 56 ein. Die Spannungseinstelleinheit 18 erhöht die Versorgungsspannung 56 der ersten Schaltertreibereinheit 10. Die Erfassungseinheit 22 erfasst einen zu dem höheren Wert der Versorgungsspannung 56 korrelierten neuen Eingangsstrom 26 und bewirkt wie beschrieben, dass die Spannungseinstelleinheit 18 einen weiteren höheren Wert der Versorgungsspannung 56 einstellt. Die Erhöhung der Versorgungsspannung 56 der ersten Schaltertreibereinheit 10 bewirkt eine schnelle Ladung des Bootstrapkondensators 28. Die schnelle Ladung des Bootstrapkondensators 28 bewirkt einen verbesserten Startvorgang und reduziert vorteilhaft eine Geräuscherzeugung. Die hohe Schaltfrequenz der ersten Schaltertreibereinheit 10 bewirkt einen hohen Stromverbrauch der ersten Schaltertreibereinheit 10. Der hohe Stromverbrauch bewirkt einen hohen Eingangsstrom 26 der Schaltertreibereinheit 10. Durch die Verringerung der Schaltfrequenz während des Soft-Start verringert sich die Schaltfrequenz der ersten Schaltertreibereinheit 10.

Während der ersten Schaltperioden ist das Netzspannungspotential V₀ ist mit einer Kriechspannung überlagert, welche aufgrund von Streuinduktivitäten von Verbindungsleitungen, insbesondere von Verbindungskabeln und/oder Leiterbahnen, insbesondere nach einem Schließen der ersten Schalteinheit 12, auftreten. Die Eingangsspannung der Bootstrapeinheit 14 entspricht einer Überlagerung des Netzspannungspotentials V₀ und des Spannungspotentials der Spannungsversorgungseinheit 38. Die Bootstrapspannung V_{BS} entspricht zumindest im Wesentlichen einer Einhüllenden einer Versorgungsspannung 56 der ersten Schaltertreibereinheit 10. Demzufolge ist die Bootstrapspannung V_{BS} in einem Vergleich zu der optimalen Versorgungsspannung 56 der ersten Schaltertreibereinheit 10 zumindest in dem Startbetriebszustand und/oder in dem Dauerbetriebszustand erhöht. Die erhöhte Bootstrapspannung V_{BS} bewirkt einen erhöhten Eingangsstrom 26 der ersten Schaltertreibereinheit 10. Die erhöhte Bootstrapspannung V_{BS} bewirkt eine Eingangsstromspitze des Eingangsstroms 26 der ersten Schaltertreibereinheit 10. Die Eingangsstromspitze des Eingangsstroms 26 kann eine erhöhte Materialbeanspruchung, eine Fehlfunktion und/oder eine Zerstörung der ersten Schaltertreibereinheit 10 und/oder der ersten Schalteinheit 12 bewirken.

In dem Dauerbetriebszustand ist die Versorgungsspannung 56 der ersten Schaltertreibereinheit 10 durch die Anpassung der Versorgungsspannung 56 während des Startbetriebs (wie beschrieben) eingestellt. Die Versorgungsspannung 56 weist daher einen hohen Wert auf. Folglich weist auch der Eingangsstrom 26 einen hohen Wert auf, bei welchem Stromspitzen ausgebildet werden könnten. Die hohe Versorgungsspannung 56 bewirkt einen Eingangsstrom 26 der ersten Schaltertreibereinheit 10. Der Eingangsstrom 26 wird von der Erfassungseinheit 22 erfasst. Ein zu dem erfassten Eingangsstrom 26 korreliertes Signal stellt die Erfassungseinheit 22 für die Spannungseinstelleinheit 18 bereit. Die Spannungseinstelleinheit 18 stellt einen niedrigeren Wert der Versorgungsspannung 56 ein. Die Spannungseinstelleinheit 18 erniedrigt die Versorgungsspannung 56 der ersten Schaltertreibereinheit 10. Die Erfassungseinheit 22 erfasst einen zu dem niedrigeren Wert der Versorgungsspannung 56 korrelierten neuen Eingangsstrom 26 und bewirkt wie beschrieben, dass die Spannungseinstelleinheit 18 einen weiteren niedrigeren Wert der Versorgungsspannung 56 einstellt. Die Anpassungseinheit 16 bewirkt eine Anpassung des Eingangsstroms 26. Die Anpassungseinheit 16 bewirkt eine Anpassung der Versorgungsspannung 56. Die Anpassungseinheit 16 ist selbststeuernd ausgebildet. Die Anpassungseinheit 16 ist in dem Startbetriebszustand dazu vorgesehen, den Wert der Versorgungsspannung 56 unterhalb eines Schwellenwerts zu halten. Die Spannungseinstelleinheit 18 ist dazu vorgesehen, in dem Dauerbetriebszustand einen Wert der Versorgungsspannung 56 unterhalb eines Schwellenwerts zu halten. Insbesondere kann ein Schwellenwert durch die Versorgungsspannung 56 der Spannungsversorgungseinheit 38 und/oder einem davon abweichenden, insbesondere vorgegebenen, Spannungswert vorgegeben sein. In dem Dauerbetriebszustand ist folglich eine Erzeugung von Stromspitzen durch die Anpassung der Versorgungsspannung 56 reduziert, insbesondere verhindert.

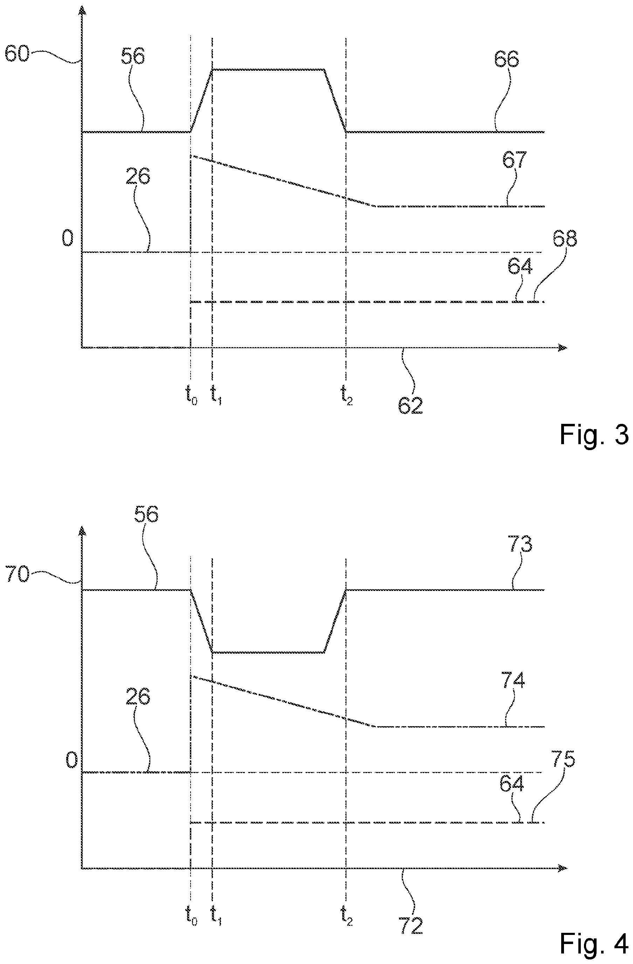

Figur 3 zeigt ein Schaubild einer Anpassung in einem Startbetriebszustand. Eine Ordinatenachse 60 ist als Größenachse ausgebildet. Eine Abszissenachse 62 ist als Zeitachse ausgebildet. Eine Kurve 66 zeigt einen Verlauf der Versorgungsspannung 56. Eine weitere Kurve 67 zeigt einen Verlauf des Eingangsstroms 26. Eine zusätzliche Kurve 68 zeigt einen Verlauf eines Aktivierungssignals 64.

Die Steuereinheit 50 startet den Soft Start durch ein Aktivierungssignal 64 zu einem Startzeitpunkt t₀. Das Aktivierungssignal 64 bewirkt eine hohe Schaltfrequenz, womit ein Stromverbrauch der ersten Schaltertreibereinheit 10 direkt auf einem Maximalwert ist. Folglich ist der Eingangsstrom 26 auf einem Maximalwert. Die Spannungseinstelleinheit 18 stellt eine maximale Versorgungsspannung 56 bereit. Die Versorgungsspannung 56 ist zu einem Zeitpunkt t₁ bei einem Maximalwert. Der Bootstrapkondensator 28 der Bootstrapeinheit 14 ist zum Zeitpunkt t₁ vollständig geladen. Daher ist eine Geräuscherzeugung unterdrückt. Die Steuereinheit 50 reduziert die Schaltfrequenz, insbesondere die Frequenz des Aktivierungssignals 64, wodurch der Eingangsstrom 26 der ersten Schaltertreibereinheit 10 sinkt. Zu einem Zeitpunkt t₂ regelt die Spannungseinstelleinheit 18 der Anpassungseinheit 16 die Versorgungsspannung 56 wieder auf 0 V. Zum Zeitpunkt t₂ regelt sich der Eingangsstrom 26 in einem Arbeitsbereich der Heizeinheit 34.

Figur 4 zeigt ein schematisches Schaubild einer weiteren Anpassung in einem Dauerbetriebszustand. Die weitere Anpassung kann alternativ oder zusätzlich in dem Startbetriebszustand erfolgen. Eine Ordinatenachse 70 ist als Größenachse ausgebildet. Eine Abszissenachse 72 ist als Zeitachse ausgebildet. Eine Kurve 73 zeigt einen Verlauf der Versorgungsspannung 56. Eine weitere Kurve 74 zeigt einen Verlauf des Eingangsstroms 26. Eine zusätzliche Kurve 75 zeigt einen Verlauf eines Aktivierungssignals 64.

Die Steuereinheit 50 startet den Soft-Start durch ein Aktivierungssignal 64 zu einem Startzeitpunkt t₀. Das Aktivierungssignal 64 bewirkt eine hohe Schaltfrequenz, womit der Stromverbrauch der ersten Schaltertreibereinheit 10 direkt auf einem Maximalwert ist. Folglich ist der Eingangsstrom 26 auf einem Maximalwert. Die Spannungseinstelleinheit 18 stellt im Soft-Start zum Startzeitpunkt t₀ eine maximale Versorgungsspannung 56 bereit. Aufgrund von Überspannungen der Bootstrapeinheit 14 kann der Eingangsstrom 26 Stromspitzen aufweisen. Das Erfassungselement 24 der Erfassungseinheit 22 erfasst den Eingangsstrom 26. Die Erfassungseinheit 22 sendet ein zu dem Eingangsstrom 26 korreliertes Signal an die Spannungseinstelleinheit 18. Die Spannungseinstelleinheit 18 reduziert die Versorgungsspannung 56 auf ein Minimum zu einem Zeitpunkt t₁. Der Eingangsstrom 26 sinkt. Die Steuereinheit 50 reduziert die Schaltfrequenz, wodurch der Eingangsstrom 26 der ersten Schaltertreibereinheit 10 sinkt. Zu einem Zeitpunkt t₂ regelt die Spannungseinstelleinheit 18 der Anpassungseinheit 16 die Versorgungsspannung 56 wieder auf einen Maximalwert. Zum Zeitpunkt t₂ regelt sich der Eingangsstrom 26 in einem Arbeitsbereich der Heizeinheit 34. Die Versorgungsspannung 56 bleibt im Arbeitsbereich auf einem Maximalwert.

### Bezugszeichen

- 10: Schaltertreibereinheit
- 11: Schaltertreibereinheit
- 12: Schalteinheit
- 13: Schalteinheit
- 14: Bootstrapeinheit
- 16: Anpassungseinheit
- 18: Spannungseinstelleinheit
- 20: Hauptenergieversorgung
- 22: Erfassungseinheit
- 24: Erfassungselement
- 26: Eingangsstrom
- 28: Bootstrapkondensator
- 29: Bootstrapdiode
- 30: Haushaltsgerät
- 32: Kochfeldplatte
- 34: Heizeinheit
- 36: Wechselrichter
- 38: Spannungsversorgungseinheit
- 42: Schaltelement
- 43: Schaltelement
- 44: Mittelabgriff
- 46: Resonanzeinheit
- 48: Treiberschaltkreis
- 50: Steuereinheit
- 52: Leitungspfad
- 54: Referenzpotential
- 56: Versorgungsspannung
- 60: Ordinatenachse
- 62: Abszissenachse
- 64: Aktivierungssignal
- 66: Kurve
- 67: Kurve
- 68: Kurve
- 70: Ordinatenachse
- 72: Abszissenachse
- 73: Kurve
- 74: Kurve
- 75: Kurve
- 76: Freilaufdiode
- 77: Freilaufdiode
- 78: Snubberkapazität
- 79: Snubberkapazität
- 80: Gleichrichter
- V₀: Netzspannungspotential
- V_{BS}: Bootstrapspannung
- t₀: Startzeitpunkt
- t₁: Zeitpunkt
- t₂: Zeitpunkt

## Patentansprüche

1. Haushaltsgerätevorrichtung, insbesondere Gargerätevorrichtung, mit zumindest einer Schaltertreibereinheit (10), welche dazu vorgesehen ist, zumindest eine Schalteinheit (12) zu versorgen, und mit einer Bootstrapeinheit (14), welche zur Bereitstellung zumindest einer Versorgungsspannung (56) für die Schaltertreibereinheit (10) vorgesehen ist, und mit zumindest einer Anpassungseinheit (16), welche in zumindest einem Betriebszustand zur Anpassung der Versorgungsspannung (56) in Abhängigkeit von zumindest einer elektrischen Schaltertreiberkenngröße der Schaltertreibereinheit (10) vorgesehen ist, **dadurch gekennzeichnet, dass** die Anpassungseinheit (16) eine Erfassungseinheit (22) aufweist, welche zu einer Erfassung der Schaltertreiberkenngröße vorgesehen ist.

2. Haushaltsgerätevorrichtung nach Anspruch 1, **dadurch gekennzeichnet, dass** die Schalteinheit (12) als eine High-Side-Leistungsschalteinheit ausgebildet ist.

3. Haushaltsgerätevorrichtung nach Anspruch 1 oder 2, **dadurch gekennzeichnet, dass** die Anpassungseinheit (16) eine Spannungseinstelleinheit (18) umfasst, welche elektrisch zwischen einer Spannungsversorgungseinheit (38) und der Bootstrapeinheit (14) geschalten und dazu vorgesehen ist, die Versorgungsspannung (56) anzupassen.

4. Haushaltsgerätevorrichtung nach Anspruch 3, **dadurch gekennzeichnet, dass** die Spannungseinstelleinheit (18) dazu vorgesehen ist, in zumindest einem Startbetriebszustand die Versorgungsspannung (56) zu erhöhen.

5. Haushaltsgerätevorrichtung nach Anspruch 3 oder 4, **dadurch gekennzeichnet, dass** die Spannungseinstelleinheit (18) dazu vorgesehen ist, in zumindest einem Dauerbetriebszustand einen Wert der Versorgungsspannung (56) unterhalb einem Schwellenwert zu halten.

6. Haushaltsgerätevorrichtung nach einem der vorhergehenden Ansprüche, **dadurch gekennzeichnet, dass** die Schaltertreiberkenngröße ein elektrischer Eingangsstrom (26) der Schaltertreibereinheit (10) ist und die Erfassungseinheit (22) dazu vorgesehen ist, den elektrischen Eingangsstrom (26) zu erfassen.

7. Haushaltsgerätevorrichtung nach einem der vorhergehenden Ansprüche, **dadurch gekennzeichnet, dass** die Erfassungseinheit (22) zumindest ein als Stromsensor ausgebildetes Erfassungselement (24) aufweist.

8. Haushaltsgerät (30), insbesondere Gargerät, mit zumindest einer Haushaltsgerätevorrichtung nach einem der vorhergehenden Ansprüche.

9. Verfahren zum Betrieb einer Haushaltsgerätevorrichtung nach einem der Ansprüche 1 bis 7, welche zumindest eine Schaltertreibereinheit (10), welche dazu vorgesehen ist, zumindest eine Schalteinheit (12) zu versorgen, und eine Bootstrapeinheit (14) umfasst, welche zur Bereitstellung zumindest einer Versorgungsspannung (56) für die Schaltertreibereinheit (10) vorgesehen ist, wobei in zumindest einem Betriebszustand die Versorgungsspannung (56) in Abhängigkeit von zumindest einer elektrischen Schaltertreiberkenngröße der Schaltertreibereinheit (10) erfasst und angepasst wird.

## Claims

1. Household appliance apparatus, in particular a cooking appliance apparatus, having at least one switch driver unit (10) which is provided so as to supply at least one switching unit (12), and having a bootstrap unit (14) which is provided so as to provide at least one supply voltage (56) for the switch driver unit (10), and having at least one adapting unit (16) which is provided so as in at least one operating state to adapt the supply voltage (56) in dependence upon at least one electrical switch driver parameter of the switch driver unit (10),
**characterised in that** the adapting unit (16) has a detecting unit (22) which is provided so as to detect the switch driver parameter.

2. Household appliance apparatus according to claim 1, **characterised in that** the switching unit (12) is designed as a high side power switching unit.

3. Household appliance apparatus according to claim 1 or 2, **characterised in that** the adapting unit (16) comprises a voltage adjusting unit (18) which is electrically switched between a voltage supply unit (38) and the bootstrap unit (14) and is provided so as to adapt the supply voltage (56).

4. Household appliance apparatus according to claim 3, **characterised in that** the voltage adjusting unit (18) is provided so as in at least one start-up operating state to increase the supply voltage (56).

5. Household appliance apparatus according to claim 3 or 4, **characterised in that** the voltage adjusting unit (18) is provided so as in at least one continuous operating state to maintain a value of the supply voltage (56) below a threshold.

6. Household appliance apparatus according to one of the preceding claims, **characterised in that** the switch driver parameter is an electrical input current (26) of the switch driver unit (10) and the detecting unit (22) is provided so as to detect the electrical input current (26).

7. Household appliance apparatus according to one of the preceding claims, **characterised in that** the detecting unit (22) has at least one detecting element (24) that is designed as a current sensor.

8. Household appliance (30), in particular a cooking appliance, having at least one household appliance apparatus according to one of the preceding claims.

9. Method for operating a household appliance apparatus according to one of claims 1 to 7 which comprises at least one switch driver unit (10), which is provided so as to supply at least one switching unit (12), and a bootstrap unit (14) which is provided so as to provide at least one supply voltage (56) for the switch driver unit (10),
wherein
in at least one operating state the supply voltage (56) is detected and adapted in dependence upon at least one electrical switch driver parameter of the switch driver unit (10).

## Revendications

1. Dispositif pour appareil ménager, en particulier dispositif pour appareil de cuisson, comprenant au moins une unité de circuit de commande de commutateur (10), qui est conçue pour alimenter au moins une unité de commutateur (12), et une unité d'amorçage (14), qui est conçue pour fournir au moins une tension d'alimentation (56) pour l'unité de circuit de commande de commutateur (10), et avec au moins une unité d'adaptation (16), qui est conçue pour adapter, dans au moins un état de fonctionnement, la tension d'alimentation (56) en fonction d'au moins un paramètre électrique de circuit de commande de commutateur de l'unité de circuit de commande de commutateur (10), **caractérisé en ce que** l'unité d'adaptation (16) comprend une unité de détection (22), qui est conçue pour détecter le paramètre de circuit de commande de commutateur.

2. Dispositif pour appareil ménager selon la revendication 1, **caractérisé en ce que** l'unité de commutateur (12) est conçue sous forme d'une unité de commutateur de puissance du côté de haute tension.

3. Dispositif pour appareil ménager selon la revendication 1 ou 2, **caractérisé en ce que** l'unité d'adaptation (16) comprend une unité de réglage de tension (18), qui est connectée électriquement entre une unité d'alimentation de tension (38) et l'unité d'amorçage (14) et qui est conçue pour adapter la tension d'alimentation (56).

4. Dispositif pour appareil ménager selon la revendication 3, **caractérisé en ce que** l'unité de réglage de tension (18) est conçue de manière à augmenter la tension d'alimentation (56) dans au moins un état de fonctionnement de démarrage.

5. Dispositif pour appareil ménager selon la revendication 3 ou 4, **caractérisé en ce que** l'unité de réglage de tension (18) est conçue de manière à maintenir une valeur de la tension d'alimentation (56) en dessous d'une valeur de seuil dans au moins un état de fonctionnement continu.

6. Dispositif pour appareil ménager selon l'une des revendications précédentes, **caractérisé en ce que** le paramètre de circuit de commande de commutateur est un courant électrique d'entrée (26) de l'unité de circuit de commande de commutateur (10) et l'unité de détection (22) est conçue pour détecter le courant électrique d'entrée (26).

7. Dispositif pour appareil ménager selon l'une des revendications précédentes, **caractérisé en ce que** l'unité de détection (22) comprend au moins un élément de détection (24) conçu sous forme d'un capteur de courant.

8. Appareil ménager (30), en particulier appareil de cuisson, comprenant au moins un dispositif pour appareil ménager selon l'une des revendications précédentes.

9. Procédé pour faire fonctionner un dispositif pour appareil ménager selon l'une des revendications 1 à 7, lequel comprend au moins une unité de circuit de commande de commutateur (10), qui est conçue pour alimenter au moins une unité de commutateur (12), et une unité d'amorçage (14), qui est conçue pour fournir au moins une tension d'alimentation (56) pour l'unité de circuit de commande de commutateur (10), dans lequel, dans au moins un état de fonctionnement, la tension d'alimentation (56) est détectée et adaptée en fonction d'au moins un paramètre électrique de circuit de commande de commutateur de l'unité de circuit de commande de commutateur (10).
